# EUROPÄISCHE PATENTSCHRIFT

(11) **EP 2 367 202 B1**
(45) Veröffentlichungstag und Bekanntmachung des Hinweises auf die Patenterteilung: **03.12.2014**
(21) Anmeldenummer: 11151093.9
(22) Anmeldetag: 17.01.2011
(51) Int. Cl.: H01L 23/498, H01L 21/48

(54) **Verfahren zur Herstellung einer elektrisch leitenden Verbindung eines Kontaktes mit einem Gegenkontakt**
Method for producing an electrically conductive connection between a contact and a counter contact
Procédé de fabrication d'une connexion électrique entre un contact et un contre-contact

(30) Priorität: 17.03.2010 DE 102010011719
(43) Veröffentlichungstag der Anmeldung: 21.09.2011
(73) Patentinhaber: SEMIKRON Elektronik GmbH & Co. KG, 90431 Nürnberg (DE)
(72) Erfinder: Schmitt, Stefan, 90766 Fürth (DE)

(56) Entgegenhaltungen:
- DE-A1- 19 856 839
- DE-A1-102006 043 901
- DE-T2- 69 401 481
- JP-A- 1 173 694
- JP-A- 2001 236 479
- US-A- 2 900 580
- US-A1- 2005 145 608
- ADAM C SIEGEL ET AL: "Foldable Printed Circuit Boards on Paper Substrates", ADVANCED FUNCTIONAL MATERIALS, WILEY - V C H VERLAG GMBH & CO. KGAA, DE, Bd. 20, Nr. 1, 8. Januar 2010 (2010-01-08) , Seiten 28-35, XP001551577, ISSN: 1616-301X, DOI: 10.1002/ADFM.200901363 [gefunden am 2009-10-15]

## Beschreibung

Die Erfindung betrifft ein Verfahren zur Herstellung einer elektrisch leitenden Verbindung einer einen Kontakt aufweisenden Leiterbahn.

Ein derartiges Verfahren ist beispielsweise aus der DE 10 2005 053 398 B4 der Anmelderin bekannt, wobei die elektrisch leitende Verbindung des an der Oberseite der von einer Verbundfolie gebildeten Trägerfolie vorgesehenen Kontaktes mit dem an der Unterseite der Trägerfolie vorgesehenen Gegenkontakt mittels eines Dünndrahtes durch Bonden erfolgt. Zum Schutz gegen Einflüsse von außen ist die Durchkontaktierung mit einem Isoliermaterial abgedeckt.

Aus der DE 10 2004 019 567 B3 ist es bekannt, Bauelemente wie beispielsweise Leistungshalbleiterbauelement durch Drucksinterverbindungen zu kontaktieren. Drucksinterverbindungen sind beispielsweise auch in der DE 10 2007 006 706 A1 der Anmelderin offenbart.

Die Drucksinter-Verbindungstechnologie und die Bondtechnologie sind nur sehr bedingt kombinierbar. Außerdem sind Durchkontaktierungen mit gebondeten Dünndrähten prozesstechnisch aufwändig und teuer bzw. bei diversen Materialkombinationen nicht zuverlässig realisierbar.

Aus der DE 198 56 839 A1 ist eine flexible Leiterplattenstruktur bekannt, die einen flexiblen Leiterbahnträger, mehrere auf dem Leiterbahnträger verlaufende Leiterbahnen und einen ersten Abschnitt des Leiterbahnträgers aufweist, welcher zumindest eine erste Leiterbahn trägt und durch Umbiegen auf einen eine zweite Leiterbahn tragenden zweiten Abschnitt des Leiterbahnträgers umgeklappt werden kann.

Aus der JP 2001 236 479 A ist eine IC Karte, die eine flexibles Substrat und eine Spiralantenne aufweist, bekannt.

Aus der DE 10 2006 043 901 A1 ist ein elektrisches Bauelement mit einer elastischen Trägerfolie und mit einem Piezotransformator, der auf der Trägerfolie angeordnet und mit dieser verbunden ist, bekannt.

In Kenntnis dieser Gegebenheiten liegt der Erfindung die Aufgabe zugrunde, ein Verfahren der eingangs genannten Art zu schaffen, das eine einfache und zuverlässige Verbindungstechnologie erlaubt, um einen Kontakt, der an einer Trägerfolie vorgesehen ist, mit einem Gegenkontakt zu verbinden.

Diese Aufgabe wird erfindungsgemäß durch die Merkmale des Anspruches 1 gelöst.

Durch das erfindungsgemäße Verfahren ergibt sich der Vorteil, dass zusätzliche Isolierungen beispielsweise eines Gatestegs, wie sie in der oben zitierten DE 10 2007 006 706 A1 beschrieben sind, entfallen.

Der Gegenkontakt kann Teil einer Leiterbahn oder eine Kontaktfläche eines Leistungshalbleiterbauelementes bilden: Im zuerst genannten Falle geht es um ein Verfahren zur Herstellung einer elektrisch leitenden Verbindung einer den Kontakt aufweisenden ersten Leiterbahn, die auf einer ersten Seite einer Trägerfolie vorgesehen ist, mit einer den Gegenkontakt aufweisenden zweiten Leiterbahn, die auf der gegenüberliegenden zweiten Seite der Trägerfolie vorgesehen ist, wobei die Trägerfolie einem Endabschnitt der ersten Leiterbahn zugeordnet U-förmig freigestanzt wird, so dass sich ein den Kontakt aufweisender Trägerfolienlappen ergibt, der anschließend um zwei voneinander beabstandeten Faltlinien umgefaltet wird, so dass der Kontakt der ersten Leiterbahn an dem zugehörigen Gegenkontakt der zweiten Leiterbahn zu liegen kommt, wonach eine elektrisch leitende Verbindung des Kontaktes mit dem Gegenkontakt erfolgt. Die elektrisch leitende Verbindung des Kontaktes mit dem Gegenkontakt kann durch eine stoffschlüssige Verbindung erfolgen. Bei der stoffschlüssigen Verbindung kann es sich vorzugsweise um eine Sinterverbindung handeln. Desgleichen ist es möglich, dass die elektrisch leitende Verbindung des Kontaktes mit dem Gegenkontakt als kraftschlüssige Verbindung ausgestaltet ist.

Bei Durchführung des oben genannten Verfahrens hat es sich als zweckmäßig erwiesen, wenn der Trägerfolienlappen zuerst um eine zum Kontakt benachbarte erste Faltlinie und anschließend um eine von der ersten Faltlinie beabstandete zweite Faltlinie umgefaltet wird, wobei die zweite Faltlinie am Trägerfolienlappen derartig gewählt wird, dass der Kontakt der ersten Leiterbahn an dem Gegenkontakt der zweiten Leiterbahn zu liegen kommt.

Dabei können die erste Faltlinie und die davon beabstandete zweite Faltlinie miteinander einen beliebigen Winkel einschließen, zweckmäßig kann es jedoch sein, wenn die erste Faltlinie und die davon beabstandete zweite Faltlinie zueinander parallel orientiert sind.

Die erste Leiterbahn kann an der Unterseite der Trägerfolie und die zweite Leiterbahn kann an deren Oberseite ausgebildet werden.

Bei der Erfindung handelt es sich bei dem Gegenkontakt um eine Kontaktfläche, wie beispielsweise das Gate eines Leistungshalbleiterbauelementes. Erfindungsgemäß kommt ein Verfahren zur Herstellung einer elektrisch leitenden Verbindung einer einen Kontakt aufweisenden Leiterbahn, die auf einer Seite einer Trägerfolie vorgesehen ist, mit einer den Gegenkontakt aufweisenden Kontaktfläche eines Leistungshalbleiterbauelementes zur Anwendung, wobei die Trägerfolie das Leistungshalbleiterbauelement überdeckt und die Leiterbahn auf der vom Leistungshalbleiterbauelement abgewandten Seite der Trägerfolie vorgesehen ist, wobei die Trägerfolie im Bereich der Kontaktfläche mit einem Loch abgebildet wird, und wobei die Trägerfolie, einem den Kontakt aufweisenden Endabschnitt der Leiterbahn zugeordnet U-förmig freigestanzt wird, so dass sich ein Trägerfolienlappen ergibt, der anschließend um eine Faltlinie umgefaltet wird, so dass ein den Kontakt aufweisender Kontaktbereich der Leiterbahn durch das Loch in der Trägerfolie hindurch an der den Gegenkontakt aufweisenden Kontaktfläche des Leistungshalbleiterbauelements zu liegen kommt, wonach eine elektrisch leitende Verbindung des Kontaktes der Leiterbahn mit der Kontaktfläche des Leistungshalbleiterbauelementes erfolgt. Bei der elektrisch leitenden Verbindung des Kontaktes mit der Kontaktfläche kann es sich um eine stoffschlüssige Verbindung handeln. Bei der stoffschlüssigen Verbindung kann es sich vorzugsweise um eine Sinterverbindung handeln. Eine andere Möglichkeit besteht darin, dass die elektrisch leitende Verbindung des Kontaktes der Leiterbahn mit der Kontaktfläche des Leistungshalbleiterbauelementes als eine kraftschlüssige Verbindung ausgestaltet ist.

Als zweckmäßig hat es sich erwiesen, wenn die Trägerfolie mit einem Loch ausgebildet wird, dessen Rand vom Rand der Kontaktfläche des Leistungshalbleiterbauelementes beabstandet ist. Des Weiteren hat es sich als zweckmäßig erwiesen, wenn der Trägerfolienlappen aus der Trägerfolie mit einer in Richtung der Faltlinie gemessenen Breite freigestanzt wird, die an die in der gleichen Richtung gemessene Dimension der Kontaktfläche des Leistungshalbleiterbauelementes angepasst ist.

Weitere Einzelheiten, Merkmale und Vorteile ergeben sich aus der nachfolgenden Beschreibung der Erfindung in Verbindung mit den anliegenden Zeichnungen. Es zeigen:
- Figur 1: eine Draufsicht auf einen Abschnitt einer Trägerfolie mit einer ersten und einer zweiten Leiterbahn,
- Figur 2: eine der Figur 1 ähnliche Draufsicht auf die Trägerfolie gemäß Figur 1 nach der zweimaligen Umfaltung des aus der Trägerfolie freigestanzten Trägerfolienlappens,
- Figur 3: stark vergrößert schematisch einen Schnitt entlang der Schnittlinie III-III in Figur 2,
- Figur 4: eine Draufsicht auf eine ein Leistungshalbleiterbauelement überdeckende, abschnittweise gezeichnete Trägerfolie, die eine Leiterbahn aufweist,
- Figur 5: eine der Figur 4 ähnliche Darstellung, wobei die Trägerfolie freigestanzt und der freigestanzte Trägerfolienlappen zum Leistungshalbleiterbauelement hin umgefaltet worden ist, und
- Figur 6: eine schematische Darstellung entlang der Schnittlinie IV-IV in Figur 5 in einem stark vergrößerten Maßstab.

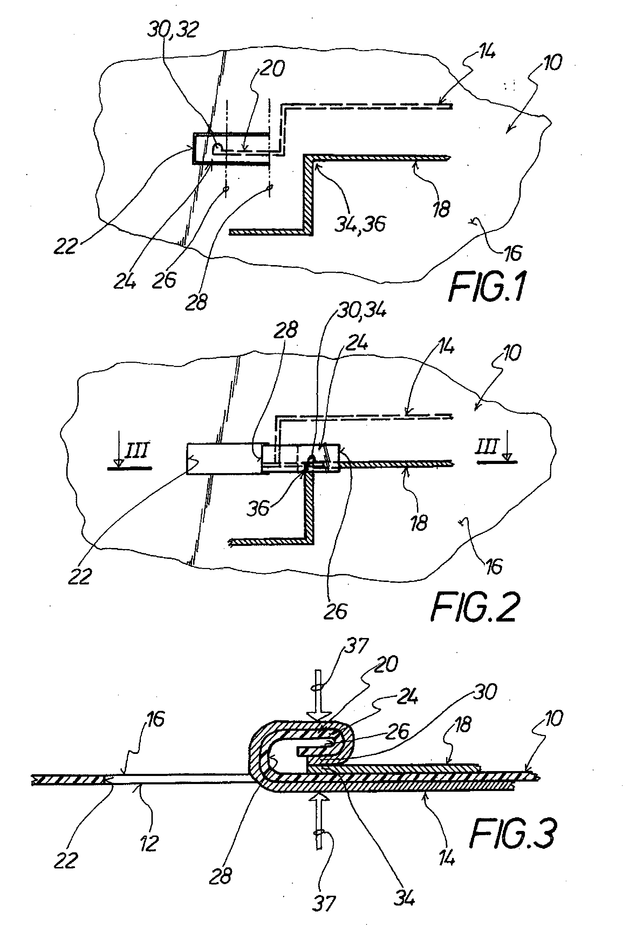

Figur 1 zeigt einen Abschnitt einer Trägerfolie 10, die an ihrer Unterseite 12 (siehe Figur 3) eine erste Leiterbahn 14 und an ihrer Oberseite 16 eine zweite Leiterbahn 18 aufweist.

Die Trägerfolie 10 wird einem Endabschnitt 20 der ersten Leiterbahn 24 zugeordnet U-förmig freigestanzt. Die U-förmige Stanzlinie ist in Figur 1 mit der Bezugsziffer 22 bezeichnet. Die U-förmige Stanzlinie 22 begrenzt einen Trägerfolienlappen 24. Der Trägerfolienlappen 24 wird um zwei voneinander beabstandete Faltlinien 26 und 28 im gleichen Faltsinn - gemäß Figur 3 im Uhrzeigersinn - umgefaltet, so dass ein einen Kontakt 30 bildender erster Kontaktbereich 32 der ersten Leiterbahn 14 an einem zugehörigen, einen Gegenkontakt 34 aufweisenden zweiten Kontaktbereich 36 der zweiten Leiterbahn 18 zu liegen kommt, wie aus Figur 2 ersichtlich ist. Anschließend erfolgt eine elektrisch leitende Verbindung des Kontaktes 30 mit dem Gegenkontakt 34. Diese elektrisch leitende Verbindung kann durch einen Drucksinter-Verfahrensschritt realisiert sein, wie er in Figur 3 durch die beiden einander zugewandten Pfeile 37 angedeutet ist.

Gleiche Einzelheiten sind in den Figuren 1 bis 3 jeweils mit denselben Bezugsziffern bezeichnet, so dass es sich erübrigt, in Verbindung mit diesen Figuren alle Einzelheiten jeweils detailliert zu beschreiben.

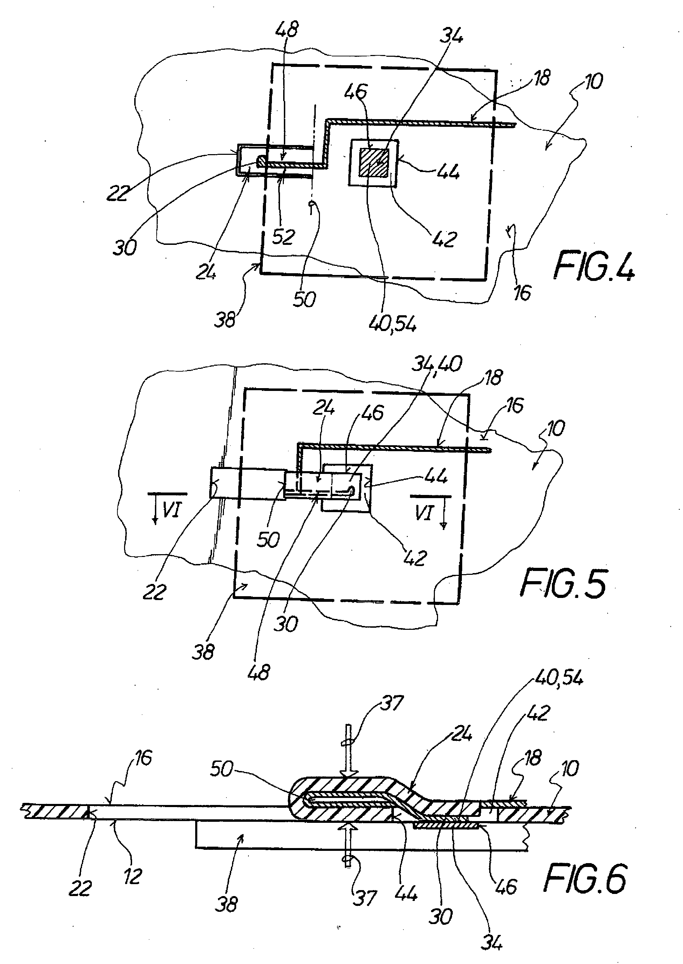

Die Figuren 4, 5 und 6 verdeutlichen die erfindungsgemäße Verfahrensvariante. Mit der Bezugsziffer 10 ist auch hier eine Trägerfolie bezeichnet. Die Trägerfolie 10 weist an ihrer Oberseite 16 eine Leiterbahn 18 auf. Die Leiterbahn 18 weist einen Kontakt 30 auf.

Die Trägerfolie 10 überdeckt ein chipförmiges Leistungshalbleiterbauelement 38, das eine Kontaktfläche 40 besitzt. Bei dieser Kontaktfläche 40 handelt es sich beispielsweise um das Gate des Leistungshalbleiterbauelementes 38.

Die Trägerfolie 10 ist im Bereich der Kontaktfläche 40 des Leistungshalbleiterbauelementes 38 mit einem Loch 42 ausgebildet, dessen Rand 44 vom Rand 46 der Kontaktfläche 40 des Leistungshalbleiterbauelementes 38 beabstandet ist.

Zur elektrisch leitenden Verbindung des Kontaktes 30 der Leiterbahn 18 mit der Kontaktfläche 40 des Leistungshalbleiterbauelementes 38 wird die Trägerfolie 10, dem den Kontakt 30 aufweisenden Endabschnitt 48 der Leiterbahn 18 zugeordnet U-förmig freigestanzt. Die entsprechende U-förmige Stanzlinie ist auch in Figur 4 mit Bezugsziffer 22 bezeichnet. Durch die U-förmige Stanzlinie 22 ist ein Trägerfolienlappen 24 begrenzt, der um eine Faltlinie 50 umgefaltet wird, so dass ein den Kontakt 30 aufweisender Kontaktbereich 52 der Leiterbahn 18 durch das Loch 42 in der Trägerfolie 10 hindurch an der einen Gegenkontakt 54 bildenden Kontaktfläche 40 des Leistungshalbleiterbauelementes 38 zu liegen kommt. Anschließend erfolgt eine elektrisch leitende Verbindung des Kontaktbereiches 52 mit der Kontaktfläche 40 des Leistungshalbleiterbauelementes 38. Bei dieser elektrisch leitenden Verbindung kann es sich um eine Drucksinterverbindung handeln, die in Figur 6 durch die beiden einander zugewandten Pfeile 37 angedeutet ist.

Gleiche Einzelheiten sind auch in den Figuren 4 bis 6 mit denselben Bezugsziffern bezeichnet, so dass es sich erübrigt, in Verbindung mit den Figuren 4 bis 6 alle Einzelheiten jeweils detailliert zu beschreiben.

### Bezugsziffernliste:

- 10: Trägerfolie
- 12: Unterseite (von 10)
- 14: erste Leiterbahn (an 12)
- 16: Oberseite (von 10)
- 18: zweite Leiterbahn (an 16)
- 20: Endabschnitt (von 14)
- 22: U-förmige Stanzlinie (in 10)
- 24: Trägerfolienlappen (von 10)
- 26: Faltlinie (von 24)
- 28: Faltlinie (von 24)
- 30: Kontakt (von 14 bi 32)
- 32: erster Kontaktbereich (von 14)
- 34: Gegenkontakt (von 18 bei 36)
- 36: zweiter Kontaktbereich (von 18)
- 37: Pfeile/elektrisch leitende Verbindung
- 38: Leistungshalbleiterbauelement
- 40: Kontaktfläche (von 38)
- 42: Loch (in 10)
- 44: Rand (von 42)
- 46: Rand (von 40)
- 48: Endabschnitt (von 18)
- 50: Faltlinie (von 24)
- 52: Kontaktbereich (von 18)
- 54: Gegenkontakt (von 38 an 40)

## Patentansprüche

1. Verfahren zur Herstellung einer elektrisch leitenden Verbindung einer einen Kontakt (30) aufweisenden Leiterbahn (18), die auf einer Seite (16) einer Trägerfolie (10) vorgesehen ist, mit einer einen Gegenkontakt (54) aufweisenden Kontaktfläche (40) eines Leistungshalbleiterbauelementes (38), wobei die Trägerfolie (10) das Leistungshalbleiterbauelement (38) überdeckt und die Leiterbahn (18) auf der vom Leistungshalbleiterbauelement abgewandten Seite (16) der Trägerfolie (10) vorgesehen ist,
wobei
die Trägerfolie (10) im Bereich der Kontaktfläche (40) des Leistungshalbleiterbauelementes (38) mit einem Loch (42) ausgebildet wird, und die Trägerfolie (10), dem Kontakt (30) zugeordnete U-förmig freigestanzt wird, so dass sich ein Trägerfolienlappen (24) ergibt, der anschließend um eine Faltlinie (50) umgefaltet wird, so dass der Kontakt (30) der Leiterbahn (18) durch das Loch (42) in der Trägerfolie (10) hindurch an der den Gegenkontakt (54) aufweisenden Kontaktfläche (40) des Leistungshalbleiterbauelementes (38) zu liegen kommt, wonach eine elektrisch leitende Verbindung (37) des Kontaktes (30) mit dem Gegenkontakt (54) der Kontaktfläche (40) erfolgt.

2. Verfahren nach Anspruch 1,
**dadurch gekennzeichnet,**
**dass** die Trägerfolie (10) mit einem Loch (42) ausgebildet wird, dessen Rand (44) vom Rand (46) der Kontaktfläche (40) des Leistungshalbleiterbauelementes (38) beabstandet ist.

3. Verfahren nach Anspruch 1,
**dadurch gekennzeichnet,**
**dass** der Trägerfolienlappen (24) aus der Trägerfolie (10) mit einer in Richtung der Faltlinie (50) gemessenen Breite freigestanzt wird, die an die in der gleichen Richtung gemessene Dimension der Kontaktfläche (40) des chipförmigen Leistungshalbleiterbauelementes (38) angepasst ist.

## Claims

1. Method for producing an electrically conductive connection of a conductor track (18), which has a contact (30) and which is provided on a side (16) of a carrier film (10), to a contact area (40) of a power semiconductor component (38), said contact area having a mating contact (54), wherein the carrier film (10) covers the power semiconductor component (38) and the conductor track (18) is provided on that side (16) of the carrier film (10) which faces away from the power semiconductor component,
wherein the carrier film (10) is formed with a hole (42) in the region of the contact area (40) of the power semiconductor component (38), and the carrier film (10) is stamped free in a U-shaped fashion in a manner assigned to the contact (30), thus resulting in a carrier film tab (24), which is subsequently folded over about a folding line (50), such that the contact (30) of the conductor track (18) becomes located, through the hole (42) in the carrier film (10), on the contact area (40) of the power semiconductor component (38) having the mating contact (54), after which an electrically conductive connection (37) of the contact (30) to the mating contact (54) of the contact area (40) is effected.

2. Method according to Claim 1,
**characterized**
**in that** the carrier film (10) is formed with a hole (42), the edge (44) of which is spaced apart from the edge (46) of the contact area (40) of the power semiconductor component (38).

3. Method according to Claim 1,
**characterized**
**in that** the carrier film tab (24) is stamped free from the carrier film (10) with a width which is measured in the direction of the folding line (50) and which is adapted to that dimension of the contact area (40) of the chip-type power semiconductor component (38) which is measured in the same direction.

## Revendications

1. Procédé de fabrication d'une connexion électrique d'une piste conductrice (18) présentant un contact (30), laquelle est prévue d'un côté (16) d'une feuille porteuse (10), avec une surface de contact (40) d'un composant semi-conducteur de puissance (38) présentant un contact conjugué (54), la feuille porteuse (10) recouvrant le composant semi-conducteur de puissance (38) et la piste conductrice (18) étant prévue sur le côté (16) de la feuille porteuse (10) opposé au composant semi-conducteur de puissance,
la feuille porteuse (10), dans la région de la surface de contact (40) du composant semi-conducteur de puissance (38), étant réalisée avec un trou (42) et la feuille porteuse (10), associée au contact (30), étant estampée en forme de U de telle sorte que l'on obtienne un volet de feuille porteuse (24) qui est ensuite replié autour d'une ligne de pliure (50), de telle sorte que le contact (30) de la piste conductrice (18) vienne s'appliquer à travers le trou (42) dans la feuille porteuse (10) au niveau de la surface de contact (40) du composant semi-conducteur de puissance (38) présentant le contact conjugué (54), ce qui produit une connexion électrique (37) du contact (30) avec le contact conjugué (54) de la surface de contact (40).

2. Procédé selon la revendication 1,
**caractérisé en ce que**
la feuille porteuse (10) est réalisée avec un trou (42) dont le bord (44) est espacé du bord (46) de la surface de contact (40) du composant semi-conducteur de puissance (38).

3. Procédé selon la revendication 1,
**caractérisé en ce que**
le volet de feuille porteuse (24) est estampé hors de la feuille porteuse (10) avec une largeur mesurée dans la direction de la ligne de pliure (50) qui est adaptée à la dimension de la surface de contact (40) du composant semi-conducteur de puissance (38) en forme de puce mesurée dans la même direction.
